# FASCICULE DE BREVET EUROPEEN

(11) **EP 2 068 164 B1**
(45) Date de publication et mention de la délivrance du brevet: **26.12.2012**
(21) Numéro de dépôt: 08291122.3
(22) Date de dépôt: 28.11.2008
(51) Int. Cl.: G01R 33/36

(54) **Procédé de réglage d'un circuit d'excitation et détection pour résonance magnétique nucléaire**
Verfahren zur Regelung einer Anregungs- und Empfangsvorrichtung für die Kernspinresonanz
Method for controlling an excitation and detection circuit for nuclear magnetic resonance

(30) Priorité: 04.12.2007 FR 0708464
(43) Date de publication de la demande: 10.06.2009
(73) Titulaire: Commissariat à l'Énergie Atomique et aux Énergies Alternatives, 75015 Paris (FR)
(72) Inventeur: Desvaux, Hervé, 91400 Orsay (FR); Marion, Denis, 33600 Pessac (FR)
(74) Mandataire: Priori, Enrico

(56) Documents cités:
- GUERON M ET AL: "NMR OF WATER PROTONS. THE DETECTION OF THEIR NUCLEAR-SPIN NOISE, AND A SIMPLE DETERMINATION OF ABSOLUTE PROBE SENSITIVITY BASED ON RADIATION DAMPING" JOURNAL OF MAGNETIC RESONANCE, ACADEMIC PRESS, ORLANDO, FL, US, vol. 85, no. 1, 15 octobre 1989 (1989-10-15), pages 209-215, XP000087265 ISSN: 1090-7807
- HUANG S Y ET AL: "Sizable concentration-dependent frequency shifts in solution NMR using sensitive probes" JOURNAL OF THE AMERICAN CHEMICAL SOCIETY 20041215 US, vol. 126, no. 49, 15 décembre 2004 (2004-12-15), pages 15936-15937, XP002489243 ISSN: 0002-7863
- GUERON M: "A coupled resonator model of the detection of nuclear magnetic resonance: Radiation damping, frequency pushing, spin noise, and the signal-to-noise ratio" MAGNETIC RESONANCE IN MEDICINE 1991 US, vol. 19, no. 1, 1991, pages 31-41, XP000209415 ISSN: 0740-3194
- MCCOY M A ET AL: "Nuclear spin noise at room temperature" CHEMICAL PHYSICS LETTERS NETHERLANDS, vol. 159, no. 5-6, juillet 1989 (1989-07), pages 587-593, XP002489847 ISSN: 0009-2614
- MISPLETER J. ET AL: "NMR Probeheads for Biophysical and Biomedical Experiments" 2006, IMPERIAL COLLEGE PRESS , LONDON , XP002489247 * page 25 - page 39 * * page 47 - page 53 * * page 76 - page 80 *
- FUKUSHIMA E. ET AL: "Experimental Pulse NMR, A Nuts and Bolts Approach" 1981, ADDISON-WESLEY PUBLISHING COMPANY , USA , XP002489248 * page 425 - page 432 *
- MARION DENIS J -Y ET AL: "An alternative tuning approach to enhance NMR signals" J. MAGN. RESON.; JOURNAL OF MAGNETIC RESONANCE JULY 2008, vol. 193, no. 1, juillet 2008 (2008-07), pages 153-157, XP002489246

## Description

L'invention porte sur un procédé de réglage d'un circuit d'excitation et détection pour résonance magnétique nucléaire (RMN) permettant d'améliorer le rapport signal sur bruit d'un signal détecté par ledit circuit.

L'invention porte également sur un circuit d'excitation et de détection pour RMN adaptée de manière à permettre la mise en oeuvre d'un tel procédé.

L'invention s'applique à des circuits comprenant une sonde du type comportant une seule bobine pour émettre une impulsion d'excitation des spins nucléaires d'un échantillon immergé dans un champ magnétique et pour détecter un signal de résonance desdits spins nucléaires. De telles sondes sont utilisées principalement en spectroscopie RMN, mais parfois également en imagerie par résonance magnétique nucléaire (IRM).

La résonance magnétique nucléaire « RMN » est une méthode d'analyse chimique précise de la matière, mais elle souffre d'un manque de sensibilité du fait des faibles énergies mises en jeu. Tout procédé permettant d'accroître cette sensibilité permettra d'étendre le champ d'application de la RMN et de sa branche la plus connue l'IRM.

Le principe de la résonance magnétique nucléaire par transformée de Fourier, qui est la méthode la plus sensible et la plus répandue actuellement, consiste à placer l'échantillon dans un champ magnétique statique extérieur B₀ et à exciter l'aimantation nucléaire M par une impulsion électromagnétique de radiofréquence, d'amplitude B₁ perpendiculaire au champ magnétique statique B₀ et dont la fréquence est proche de la fréquence de résonance f₀ = |γB₀|/2π des spins nucléaires, dite fréquence de Larmor, γ étant le rapport gyromagnétique.

Il est important de noter que comme dans la plupart des montages expérimentaux et commerciaux, la valeur du champ magnétique statique B₀ est fixée et que le rapport gyromagnétique d'un isotope considéré ne varie que très peu (variation relative inférieure à 10⁻⁴ et typiquement de l'ordre de 10⁻⁵) suivant l'environnement chimique de son atome, cela revient à admettre que la fréquence de Larmor est une constante imposée par le montage expérimental.

Après excitation, l'aimantation nucléaire décrit un mouvement de précession autour de l'axe défini par B₀ à sa fréquence de Larmor. Cette précession de l'aimantation crée, dans une bobine dont l'axe est perpendiculaire à B₀, par effet Faraday, un courant qui correspond au signal effectivement détecté. En pratique, comme le signal est faible, il est d'abord amplifié avant d'être multiplié par une référence de fréquence, typiquement celle du champ radiofréquence (RF) d'excitation. En ne conservant que la partie du signal à basse fréquence (filtre passe-bas) le signal temporel est ensuite converti numériquement, et après transformée de Fourier le spectre est déduit. Il apparaît donc qu'à côté de la bobine créant le champ magnétique B₀, au moins une autre bobine créant un champ radiofréquence B₁ perpendiculaire à B₀ est nécessaire. Dans la plupart des cas, pour des problèmes de place et de difficultés de croisement entre les bobines radiofréquence, il apparaît plus simple de n'utiliser qu'une seule bobine radiofréquence qui sert à la fois à l'excitation et à la détection. Cette bobine est associée à des éléments capacitifs afin de constituer un circuit résonant accordé à la fréquence de Larmor du signal émis par les spins nucléaires des atomes à détecter. Un circuit électronique, souvent composé de jeux de diodes têtes-bêches, placé entre ledit circuit résonant et le préamplificateur permet de séparer le circuit d'émission et le circuit de réception tout en protégeant ce dernier et en particulier le préamplificateur, des surtensions présentes lors de l'excitation [1]. Du côté de la bobine, une amélioration de la sensibilité de la détection de la RMN d'un facteur Q^{1/2} avec Q=2πLfᵣ/r, où L est l'inductance de la bobine et r sa résistance, est obtenue en accordant la fréquence de résonance fᵣ du circuit résonant contenant la bobine à la fréquence de Larmor f₀. Pour cela, des capacités variables sont ajoutées en série et en parallèle. Ce circuit électronique comprenant la bobine et les capacités d'accord est appelé tête de mesure ou sonde, et constitue la partie principale du circuit d'excitation et détection. Un deuxième accord en impédance est nécessaire. Il consiste à adapter l'impédance de la sonde à l'impédance de l'amplificateur du circuit d'émission afin, entre autres, que la puissance délivrée par ce dernier ne soit pas réfléchie. L'accord est généralement fait à 50 Ω.

En pratique, du fait des fréquences de Larmor élevées associées au champ magnétique statique, de quelques dizaines à plusieurs centaines de MHz, le circuit d'accord de la sonde est un circuit réactif qui comprend généralement un condensateur, dit d'accord ou de « tuning» désigné par la valeur Cₜ de sa capacité, placé généralement en parallèle de la bobine, dont l'objet principal est d'ajuster la fréquence de résonance du circuit électronique fᵣ à la fréquence de Larmor f₀ des spins nucléaires des atomes à détecter et un condensateur dit d'adaptation ou de « matching » désigné par la valeur Cₘ de sa capacité, placé généralement en série du montage en parallèle de la bobine et de la capacité d'accord Cₜ, qui vise alors à adapter l'impédance de la sonde à 50 Ω. L'ajustement expérimental, qui dépend des pertes électriques dans l'échantillon, des valeurs des condensateurs ajustables d'accord (de capacité Cₜ) et d'adaptation (de capacité Cₘ), est généralement déterminé soit en étudiant la réponse du circuit résonant contenant la bobine obtenue grâce à un circuit « balun » (ou « symétriseur ») LC connecté à un vobulateur, soit en minimisant le signal réfléchi vers l'amplificateur. Dans tous les cas il correspond à un accord du circuit de résonance de la sonde en émission à la fréquence de Larmor des spins nucléaires des atomes à détecter.

Normalement, on considère que l'accord du circuit de résonance de la sonde en émission suffit pour obtenir un accord satisfaisant dudit circuit de résonance en réception. En d'autres termes, on considère que les fréquences de résonance en réception et en émission de la sonde RMN sont sensiblement les mêmes.

Or, les inventeurs se sont rendus compte du fait que lorsque la fréquence de résonance en émission de la sonde est parfaitement accordée à la fréquence de Larmor de l'aimantation nucléaire des atomes à détecter, cette même sonde se trouve désaccordée en réception. Ce désaccord est dû à des facteurs divers, tels que la longueur des câbles, les capacités parasites des diodes, etc. Contrairement à l'opinion courante dans l'art de la spectroscopie RMN, les inventeurs ont réalisé que ce désaccord est loin d'être négligeable, et peut se chiffrer en plusieurs dizaines voire centaines de kilohertz (kHz) dans une grande partie, voire dans la totalité, des sondes RMN et des montages du commerce. Un tel décalage se traduit par une baisse de la puissance du signal reçu et par une dégradation de son rapport signal sur bruit de l'ordre de 1dB ou plus, ce qui est considérable.

Un but de l'invention est donc de fournir un procédé de réglage d'une sonde pour résonance magnétique nucléaire, du type comportant une seule bobine fonctionnant aussi bien en émission qu'en réception, permettant d'augmenter la puissance du signal de résonance détecté ce qui contribue à en accroître le rapport signal sur bruit.

Conformément à l'invention, un tel but est atteint par un procédé de réglage d'un circuit d'excitation et détection pour résonance magnétique nucléaire, comprenant une sonde, du type comportant une seule bobine pour émettre des impulsions d'excitation des spins nucléaires d'un échantillon immergé dans un champ magnétique et pour détecter un signal de résonance desdits spins nucléaires, ledit procédé étant caractérisé par une étape d'accord de la fréquence de résonance en réception de ladite sonde à la fréquence de Larmor des spins nucléaires des atomes à détecter, au moyen d'au moins un élément électrique ajustable et une étape d'accord de la fréquence de résonance en émission de ladite sonde à la fréquence de Larmor des spins nucléaires des atomes à détecter, ainsi que son adaptation d'impédance avec un circuit de génération desdites impulsions d'excitation, au moyen d'au moins un élément électrique ajustable distinct.

Par accord de la fréquence de résonance en réception, on entend un ajustement de la fréquence propre du circuit de réception sur la fréquence de Larmor. Ce circuit de réception comporte au minimum la sonde et des moyens de réglage en fréquence et en impédance. Les moyens de réglage en fréquence et en impédance sont généralement des condensateurs ajustables ; toutefois n'importe quel autre moyen de réglage ne dégradant pas le coefficient de qualité de la bobine de plus de 10 % peut convenir, comme par exemple des circuits réactifs.

L'ajustement de la fréquence propre du circuit de réception sur la fréquence de Larmor peut se faire selon plusieurs variantes décrites ci-après.

Selon une première variante préférentielle d'ajustement de la fréquence en réception, on débute par une première phase d'accord et d'adaptation d'impédance de la sonde en émission, en utilisant pour cela une des techniques de l'état de l'art antérieur. Dans la pratique une méthode usuelle et fiable consiste à placer un échantillon à analyser dans la sonde et à générer un signal vobulé, soit par une consigne appropriée à l'entrée du générateur de l'appareil de RMN, soit en remplaçant ce générateur par un vobulateur suivi d'un amplificateur délivrant un niveau comparable à celui du générateur. On étudie alors la réponse de la sonde à travers un circuit « balun » (ou symétriseur ») LC référencé par rapport à l'impédance du générateur d'impulsion d'excitation des spins nucléaires. On ajuste alors le circuit résonant de la sonde afin d'accorder sa fréquence de résonance à la fréquence de Larmor et afin d'adapter son impédance à celle du générateur d'impulsions d'excitation des spins nucléaires. Cette étape préalable étant faite, afin d'assurer l'accord de fréquence en réception, on cesse d'émettre et on observe le signal en sortie du préamplificateur par le spectromètre de Résonance Magnétique Nucléaire. On retouche alors légèrement le moyen d'accord en fréquence (généralement un condensateur de capacité Cₜ, et éventuellement une itération de réglage avec le condensateur de capacité Cₘ réglant l'impédance), de manière à maximiser le niveau moyen du bruit à la fréquence de Larmor des spins nucléaires des atomes à analyser.

Dans le cas où le circuit résonant contenant la bobine est très sélectif en fréquence, c'est-à-dire que le facteur de qualité Q du circuit est très grand, il peut subvenir que le léger décalage en fréquence induit par l'accord en fréquence en réception diminue tellement la puissance reçue par l'échantillon lors de l'excitation qu'elle n'est plus suffisante, ou que ce décalage induise, du fait de la désadaptation d'impédance à la fréquence de Larmor du circuit d'émission, le non fonctionnement du générateur d'impulsions d'excitation des spins nucléaires des atomes à détecter. On remédie alors à cet inconvénient en ajoutant entre le générateur et la sonde un second moyen d'ajustement en fréquence, constitué par exemple d'un condensateur ajustable ou d'un circuit réactif ajustable.

Selon une seconde variante préférentielle d'ajustement de la fréquence en réception, on procède comme précédemment pour ajuster et adapter le circuit résonant comprenant la bobine en émission. L'étape ultérieure d'ajustement en réception de la fréquence de résonance du circuit comprenant la bobine consiste à mesurer la réponse fréquentielle du signal de sortie du préamplificateur, par accumulation et moyenne d'un grand nombre d'acquisitions (typiquement supérieur à 100) effectuées à l'aide d'un analyseur de spectres. On obtient une courbe montrant que la résonance effective du circuit de réception diffère un peu de la fréquence de Larmor des spins nucléaires des atomes à analyser. On ajuste alors un premier paramètre d'un moyen d'ajustement en fréquence, généralement en ajustant un condensateur ajustable connecté de manière à agir sur la fréquence, pour modifier sa capacité jusqu'à ce que la résonance effective du circuit de réception soit égale à la fréquence de Larmor des spins nucléaires des atomes à analyser.

Selon une troisième variante préférentielle d'ajustement de la fréquence du récepteur, on effectue un ajustement plus précis encore en utilisant l'amortissement cohérent. Cette troisième variante sera exposée plus en détail ultérieurement, lors de l'exposé des modes de réalisation détaillés.

Selon des modes de réalisation particuliers de l'invention :
- ladite étape d'accord de la fréquence de résonance en réception de ladite sonde à la fréquence de Larmor peut comporter l'ajustement d'au moins un premier paramètre de réglage et l'observation de l'effet dudit ajustement sur le spectre du bruit électrique aux bornes d'un circuit résonant comprenant ladite bobine, en présence d'un échantillon à analyser par résonance magnétique nucléaire immergé dans un champ magnétique.
- Ledit spectre de bruit peut être mesuré pendant que l'on ajuste au moins ledit premier paramètre de réglage, ce paramètre étant ajusté jusqu'à ce que le maximum dudit spectre de bruit coïncide avec ladite fréquence de Larmor.
- Ledit spectre de bruit peut être mesuré à l'aide d'un analyseur de spectre électronique.
- Ladite étape d'accord de la fréquence de résonance en réception dudit circuit d'excitation et détection à la fréquence de Larmor peut comporter: la détermination, à l'aide d'un spectromètre à résonance magnétique nucléaire, d'un décalage entre la fréquence en correspondance de laquelle ledit spectre de bruit présente son maximum d'intensité et ladite fréquence de Larmor ; et l'accord en émission du circuit d'excitation et détection à la fréquence de Larmor modifiée dudit décalage.
- Les sous-étapes de détermination dudit décalage et d'accord en émission dudit circuit d'excitation et détection peuvent être répétées de manière itérative.
- Ladite étape d'accord de la fréquence de résonance en réception de ladite sonde à la fréquence de Larmor peut comporter : la mesure d'un spectre de bruit de spins ; et l'ajustement d'au moins ledit premier paramètre de réglage jusqu'à ce que ledit spectre de bruit de spins présente à la fréquence de résonance une absorption dont la forme est une Lorentzienne en absorption pure.
- L'accord de la fréquence de résonance en réception dudit circuit d'excitation et détection à la fréquence de Larmor des spins nucléaires des atomes à détecter peut comporter l'ajustement simultané d'au moins un premier et un deuxième paramètres, afin d'optimiser le facteur de qualité de ladite sonde en même temps que l'on accorde sa fréquence de résonance.
- Ledit premier paramètre de réglage peut être la valeur de la capacité d'un premier condensateur disposé en parallèle à ladite bobine.
- Ledit deuxième paramètre de réglage peut être la valeur de la capacité d'un deuxième condensateur disposé en série par rapport au montage en parallèle de ladite bobine et dudit premier condensateur.
- Le procédé peut comporter également une étape d'ajustement d'au moins un troisième paramètre de réglage, jusqu'à obtenir une adaptation d'impédance du circuit d'excitation et détection avec un circuit de génération de ladite impulsion d'excitation des spins nucléaires, ledit troisième paramètre étant choisi de manière à ne pas affecter, de moins en première approximation, l'accord de la fréquence de résonance en réception dudit circuit d'excitation et détection.
- Le procédé peut comporter également une étape d'ajustement d'au moins un quatrième paramètre de réglage, jusqu'à obtenir un accord en émission du circuit d'excitation et détection à la fréquence de Larmor, ledit quatrième paramètre étant choisi de manière à ne pas affecter, de moins en première approximation, l'accord de la fréquence de résonance en réception dudit circuit d'excitation et détection.
- L'adaptation d'impédance du circuit d'excitation et détection avec un circuit de génération de ladite impulsion d'excitation des spins nucléaires, ainsi que son accord en émission à la fréquence de Larmor, peuvent être obtenus par réglage d'au moins un élément électrique ajustable situé sur une ligne de transmission reliant un circuit résonant comprenant ladite bobine à un circuit de génération de ladite impulsion d'excitation des spins nucléaires, ledit élément électrique ajustable étant séparé dudit circuit résonant comprenant la bobine par un élément de découplage vu comme un circuit ouvert par le signal de résonance de spin détecté par ladite bobine.
- En variante, l'accord de fréquence en réception dudit circuit d'excitation et détection peut être obtenu par réglage d'au moins un élément électrique ajustable situé à l'entrée d'un circuit de préamplification d'un signal de résonance de spins reçu par ladite bobine, ledit élément électrique ajustable étant séparé de ladite bobine par un élément de découplage vu comme un court-circuit à la masse du circuit par les impulsions d'excitation des spins nucléaires.
- L'adaptation d'impédance dudit circuit d'excitation et détection avec un circuit de génération de ladite impulsion d'excitation des spins nucléaires, ainsi que son accord en émission à la fréquence de Larmor, peuvent être obtenus par ajustement des valeurs de capacité d'un premier et d'un deuxième condensateurs disposés respectivement en parallèle à ladite bobine et en série au montage en parallèle de ladite bobine et dudit premier condensateur.
- Lesdites étapes d'accord de fréquence en réception, et d'adaptation d'impédance et accord de fréquence en émission de ladite sonde, peuvent être répétées de manière itérative.

Un autre objet de l'invention est un circuit d'excitation et détection pour résonance magnétique nucléaire, comprenant une sonde du type comportant une seule bobine pour émettre des impulsions d'excitation des spins nucléaires d'un échantillon immergé dans un champ magnétique et pour détecter un signal de résonance desdits spins nucléaires, ledit circuit étant caractérisé en ce qu'il est adapté à la mise en oeuvre d'un procédé de réglage tel que décrit ci-dessus en ce qu'il comporte : au moins un élément électrique ajustable pour permettre l'accord de la fréquence de résonance en réception de ladite sonde à la fréquence de Larmor des spins nucléaires des atomes à détecter ; et au moins un élément électrique ajustable distinct pour permettre l'accord de la fréquence de résonance en émission de ladite sonde à la fréquence de Larmor des spins nucléaires des atomes à détecter, ainsi que son adaptation d'impédance avec un circuit de génération de ladite impulsion d'excitation des spins nucléaires.

Selon des modes de réalisation particuliers de l'invention :
- Au moins un dit élément électrique ajustable peut être situé sur une ligne de transmission reliant ladite bobine à un circuit de génération de ladite impulsion d'excitation des spins nucléaires, ledit élément réactif étant séparé de la bobine par un élément de découplage vu comme un circuit ouvert par le signal de résonance de spin détecté par ladite bobine.
- En variante, au moins un dit élément électrique ajustable peut être situé à l'entrée d'un circuit de préamplification d'un signal de résonance de spins reçu par ladite bobine et est séparé de ladite bobine par un élément de découplage vu comme un court-circuit à la masse du circuit par l'impulsion d'excitation des spins nucléaires.

D'autres caractéristiques, détails et avantages de l'invention ressortiront à la lecture de la description faite en référence aux dessins annexés donnés à titre d'exemple, dans lesquels :
- La figure 1 illustre le schéma de principe d'un circuit d'excitation et détection RMN comprenant une sonde du type comportant une seule bobine fonctionnant aussi bien en émission qu'en réception.
- La figure 1b représente un circuit d'accord en fréquence et d'adaptation en impédance de la sonde en émission.
- Les figures 2A et 2B présentent deux exemples de spectres RMN de bruit de spins. Le spectre de la figure 2A a été acquis à l'aide d'une sonde accordée en émission, c'est-à-dire conformément à l'art antérieur, tandis que celui de la figure 2B a été acquis à l'aide d'une sonde accordée en réception, conformément à l'invention.
- Les figures 3A et 3B montrent deux spectres du bruit électrique aux bornes d'une sonde RMN accordée en émission (figure 3A) et en réception (figure 3B), mettant en évidence la différence de fréquence d'accord entre l'émission et la réception.
- Les figures 4A et 4B montrent une portion du spectre RMN correspondant aux protons du CH₂ d'un groupement éthyle. Le spectre a été acquis à l'aide d'une sonde RMN accordée en émission (figure 4A) et de la même sonde accordée en réception (figure 4B), ce qui permet de mettre en évidence le gain en termes d'intensité du signal qui peut être obtenu grâce à l'invention.
- La figure 5 illustre l'amélioration du rapport signal sur bruit qui peut être obtenue par la mise en oeuvre de l'invention.

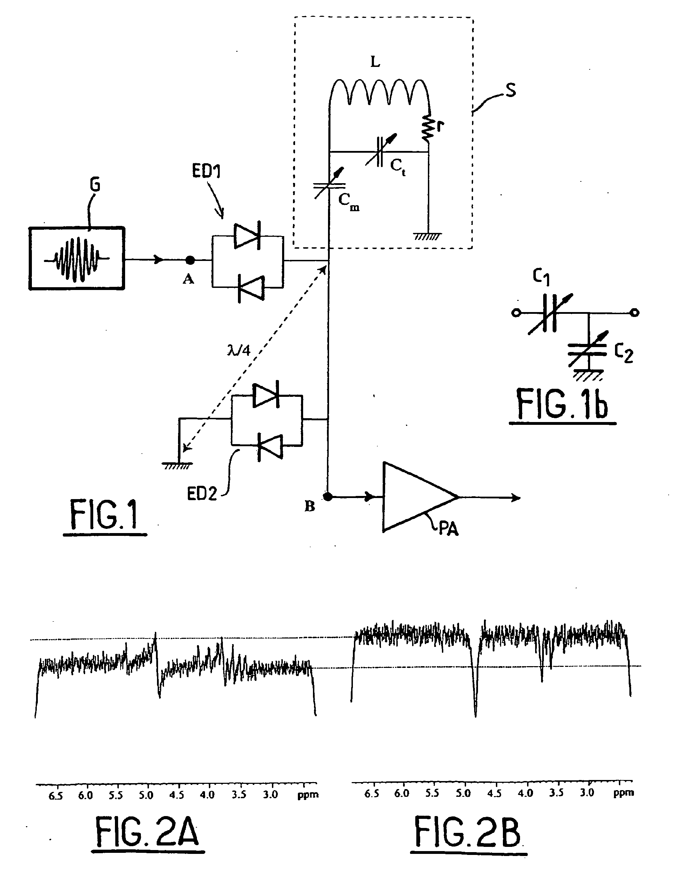

La Figure 1 illustre le schéma de principe du circuit électronique de la sonde S d'un spectromètre RMN. Une telle sonde est connue de l'art antérieur, et en particulier du document [1].

La bobine d'excitation, schématisée par une inductance L connectée en série à une résistance r, sert à créer le champ RF d'excitation et à détecter le signal de résonance magnétique nucléaire. Les condensateurs ajustables de capacité variable Cₜ (en parallèle) et Cₘ (en série) forment, avec ladite bobine, un circuit résonant. La fréquence de résonance de ce circuit dépend principalement de la capacité d'accord Cₜ, tandis que son impédance est essentiellement déterminée par la capacité d'adaptation Cₘ. Ainsi, il est possible de régler de manière indépendante ces deux paramètres (en réalité, un ajustement de Cₜ introduit également une modification de l'impédance, et réciproquement Cₘ a un effet sur la fréquence de résonance ; par conséquent, le réglage se fait généralement de manière itérative).

La sonde S est connectée, par l'intermédiaire de lignes de transmission, à un circuit G de génération d'impulsions RF d'excitation des spins nucléaires et à un préamplificateur PA, destiné à amplifier le faible signal de résonance détecté par la bobine de la sonde. Il est important que l'impulsion d'excitation, très intense, ne puisse pas atteindre l'entrée du préamplificateur PA, et que le faible signal de résonance ne se disperse pas sur la ligne du générateur G. La séparation du circuit d'émission et de réception est assurée par deux éléments de découplage ED1, disposé en série au générateur G, et ED2, monté en dérivation à l'entrée du préamplificateur PA. Chacun des deux éléments de découplage ED1, ED2 est constitué par deux jeux de diodes montées tête-bêche en parallèle. Ces diodes apparaissent comme des courts-circuits pour des signaux intenses (comme l'impulsion d'excitation) et comme des circuits ouverts pour des signaux faibles (comme le signal de résonance détecté). La distance entre la sortie de l'élément de découplage ED1 (côté bobine) et la masse électrique via ED2 est égale à un quart de la longueur d'onde (λ/4) à la fréquence de Larmor des spins nucléaires.

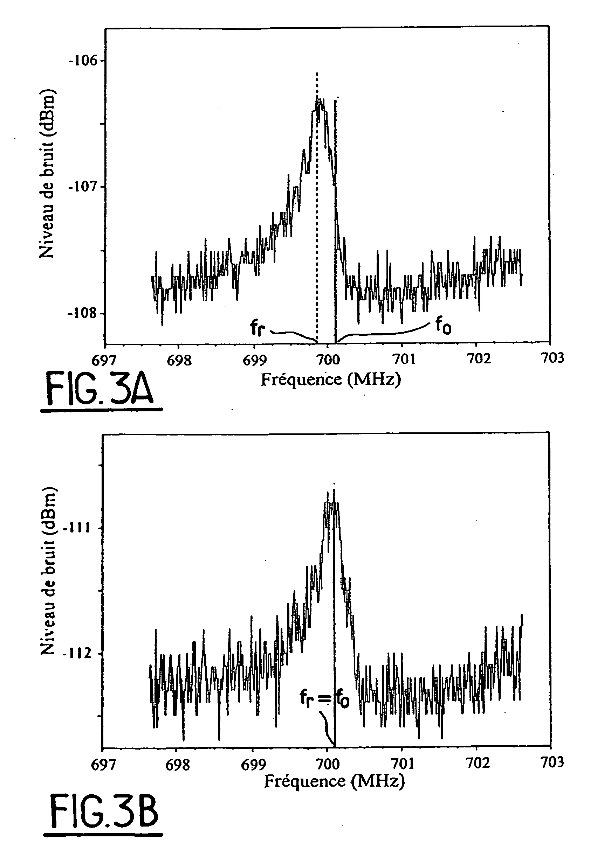

Un premier mode de réalisation du procédé de réglage de la sonde S selon l'invention sera maintenant décrit en référence aux figures 3A et 3B. Ces deux figures montrent le spectre du bruit électrique en tension aux bornes d'une cryosonde TCI, amplifié par le préamplificateur PA, en présence d'un échantillon de référence d'éthyl-benzène dans du chloroforme deutéré à 0.1% immergé dans un champ magnétique B₀ de 16,5 T ; les spectres ont été acquis au moyen d'un analyseur E4411 B d'Agilent Technologies. Pour acquérir ces spectres de bruit, une succession rapide d'acquisitions sans impulsion d'excitation préalable a été programmée sur le spectromètre et le signal issu du préamplificateur a été directement détecté par l'analyseur de spectres.

La figure 3A correspond au cas où la sonde S est accordée en émission à la fréquence de Larmor pour l'échantillon dans le champ B₀, f₀=700,13 MHz. Les moyens de réglage en fréquence et en impédance étant des condensateurs ajustables de capacité Cₜ et Cₘ, l'accord est obtenu en les ajustant à une valeur déterminée grâce à la réponse observée en utilisant la fonction vobulateur du spectromètre associée à un circuit symétriseur (« balun ») LC. Un spectre similaire est obtenu en ajustant ces mêmes capacités à des valeurs déterminées à l'aide d'un circuit symétriseur (« balun ») LC externe et d'un vobulateur externe, ou à celles déterminées par la minimisation des réflexions entre la sonde et le générateur.

On peut observer sur cette figure que le maximum du spectre du bruit, qui est situé au niveau de la fréquence de résonance en détection du circuit de résonance de la sonde, fᵣ=699,8MHz, est décalé de 330kHz de la fréquence de Larmor des protons de l'échantillon dans le champ B₀: f₀=700,13MHz.

Un procédé de réglage, selon l'invention, comporte l'ajustement des valeurs de Cₜ et Cₘ jusqu'à ce que le maximum du spectre de bruit coïncide avec la fréquence de Larmor f₀=700,13 MHz. En principe, l'accord en fréquence pourrait être obtenu en agissant uniquement sur la capacité d'accord Cₜ, mais cela dégraderait le facteur de qualité Q du circuit. En agissant à la fois sur les deux capacités, selon la procédure itérative déjà évoquée, il est possible d'accorder la sonde S en fréquence tout en optimisant son facteur de qualité.

La courbe de la figure 3B illustre le résultat après une telle manipulation. On peut noter un accord entre la fréquence du maximum de réception et la fréquence de résonance des protons dans ce champ (700,13MHz). La comparaison des niveaux de bruit sur ces deux figures pour un désaccord de 330kHz montre que l'utilisation d'une sonde réglée conformément à l'invention permet d'augmenter le niveau du signal RMN d'environ 1,1 dB, soit plus de 25%.

Ce premier mode de réalisation du procédé de réglage de l'invention présente l'avantage d'être simple et rapide, car l'acquisition des spectres de bruit se fait quasiment en temps réel. Sa limitation réside dans le fait que le simple fait de brancher un analyseur de spectre à la sortie du préamplificateur PA modifie légèrement la fréquence de résonance du circuit complet de réception. L'accord ainsi obtenu ne peut donc pas être parfait.

Un deuxième mode de réalisation de l'invention permet de surmonter cette limitation en utilisant le spectromètre RMN lui-même comme moyen d'acquisition du spectre de bruit.

Tout d'abord le spectre de puissance est acquis par la même séquence que précédemment en utilisant une grande bande passante (typiquement plusieurs centaines de kilohertz) et le spectromètre RMN comme système d'acquisition. Sur cette bande passante, on détermine la fréquence pour laquelle le bruit est maximum. Ensuite en utilisant une méthode d'ajustement de la fréquence de résonance de la sonde en émission (vobulateur ou analyseur de réflexion) les valeurs des capacités Cₘ et Cₜ sont optimisées afin de décaler la fréquence de résonance de la sonde de l'écart observé. En d'autres termes, l'ajustement des valeurs de ces capacités se fait « à l'aveugle » par dichotomie, car l'acquisition du spectre de bruit par l'intermédiaire du spectromètre RMN est actuellement trop lente pour permettre un réglage en « temps réel », comme lorsqu'on utilise un analyseur de spectre.

Pour affiner le réglage, il est donc opportun d'itérer la procédure.

Un troisième mode de réalisation du procédé, permettant un accord encore plus précis du circuit résonant de la sonde, se base sur un effet connu comme amortissement cohérent ou, pour sa dénomination en anglais, « radiation damping ». La description du troisième mode de réalisation sera donc précédée par une explication de cet effet.

La précession de l'aimantation des spins nucléaires de l'échantillon crée, par induction, un courant dans la bobine de la sonde ; c'est justement la tension associée à ce courant qui constitue le signal RMN détecté. Ce courant circulant dans la bobine de la sonde crée, à son tour, un champ magnétique à la fréquence de Larmor. Ce champ rétroagit sur l'aimantation et a pour effet de provoquer un «couple» qui tend à faire retourner l'aimantation le long du champ statique [2]. C'est l'amortissement cohérent. L'importance de ce phénomène est caractérisée par le temps τ_{RD}=2/µ₀ηQγM, où µ₀ est la perméabilité magnétique du vide et η le facteur de remplissage de la bobine. La direction de ce champ radiofréquence forme un angle ψ = atan(fᵣ²f₀ /Qfᵣ(fᵣ²-f₀²)) avec la direction de l'aimantation transversale et est parfaitement en quadrature quand la fréquence de résonance du circuit est égale à celle de Larmor. Dépendant de l'aimantation, le phénomène d'amortissement cohérent qui est associé à des phénomènes de réponses non linéaires, devient important à hautes fréquences, pour des échantillons concentrés et quand des sondes présentant de très bons facteurs de qualité sont employées. Ce sont des conditions qui sont rencontrées de plus en plus souvent du fait de l'amélioration des techniques de fabrication des sondes et des aimants. Les conséquences sur le spectre de ce phénomène sont nombreuses, on peut signaler un élargissement des raies pour des petits angles d'excitation, la présence d'oscillations dans le spectre pour des angles d'excitation supérieurs à 90° [3]. Une phase entre le champ de rétroaction et l'aimantation différente de 90° (cas où fᵣ est différent de f₀) induit qu'après transformée de Fourier, la forme de la raie de résonance des signaux présentant des effets d'amortissement cohérent n'est plus symétrique par rapport à la fréquence pour laquelle l'intensité est maximale. Une telle raie asymétrique n'est plus purement absorptive (figure 2B), mais présente également une composante dispersive (2A). Pour un décalage de fréquence d'accord donné, cet effet est d'autant plus marqué que le facteur de qualité Q de la bobine est élevé ; or, les sondes pour résonance magnétique nucléaire se caractérisent généralement par un facteur de qualité important.

La méthode de choix pour détecter la résonance magnétique nucléaire est celle qui est basée sur la transformée de Fourier du signal acquis temporellement après excitation par une impulsion radiofréquence de l'aimantation nucléaire. Le spectre peut également être obtenu par la méthode dite de « bruit de spins » quand la concentration des produits est suffisante pour que l'effet d'amortissement cohérent apparaisse affectant, par exemple, leur largeur de raie [4]. Dans cette méthode, partant d'un système de spins nucléaires à l'équilibre thermodynamique placés dans un champ magnétique B₀, aucune excitation n'est appliquée, le signal temporel est simplement enregistré et les spectres de puissances calculés puis sommés. En additionnant de tels spectres, on constate que le niveau de bruit est abaissé aux fréquences de résonance des aimantations présentant un effet d'amortissement cohérent : le système de spins nucléaires absorbe le bruit de la bobine à ces fréquences et on en déduit ainsi le spectre. La description physique de ce phénomène présente de nombreuses analogies avec le processus d'émission [5]. Dans de telles conditions si le circuit électronique de détection est accordé à la fréquence de Larmor on observe autour d'un signal de bruit moyen des creux dont la forme est une lorentzienne et qui correspondent aux résonances des spins nucléaires. Quand fᵣ n'est pas égal à f₀ alors le signal observé est un mélange de la partie en absorption et en dispersion d'une lorentzienne [4].

C'est cette dernière remarque qui permet d'exploiter le phénomène d'amortissement cohérent pour accorder la fréquence de résonance en réception de la sonde à la fréquence de Larmor.

La figure 2A présente un exemple de spectres RMN de bruit de spins obtenus sur un échantillon contenant 0,7g de saccharose dans 500µl de D₂O avec un spectromètre RMN Bruker à 700MHz équipé d'une cryosonde accordée en émission, conformément à l'art antérieur. La forme asymétrique de ce spectre montre que, en réception, la sonde n'est pas accordée à la fréquence de Larmor. Physiquement, ce qui se passe est que le bruit radioélectrique tend à interagir avec l'aimantation nucléaire, créant un système oscillant. Comme l'accord du circuit de réception sur la fréquence de Larmor de la raie considérée n'est pas parfait, l'énergie due au bruit excite l'aimantation nucléaire à la fréquence de Larmor et la réponse se trouve modifiée par l'oscillation propre du circuit d'accord qui est différente.

Conformément au troisième mode de réalisation du procédé de l'invention, on ajuste les valeurs des capacités Cₜ et Cₘ des condensateurs ajustables jusqu'à ce que ledit spectre présente un pic d'absorption pure, comme dans le cas de la figure 2B. Ce qui se passe dans ce cas est que l'énergie due au bruit excite l'aimantation nucléaire à sa fréquence de Larmor et sa réponse est proprement entretenue par le circuit électronique oscillant, donnant une seule raie nette, grande et symétrique.

On peut noter, dans le cas de la figure 2B, le plus fort niveau moyen de bruit (valeur moyenne de la ligne de base matérialisée par le trait pointillé ce qui rend possible une visualisation simplifiée), résultant d'un meilleur accord en réception et des signaux en absorption. L'ajustement des valeurs des capacités Cₜ et Cₘ des condensateurs ajustables peut se faire de manière à maximiser le niveau moyen du bruit, au lieu (ou en complément) d'observer la forme du pic d'absorption, conformément à ce qui a été décrit en référence au deuxième mode de réalisation.

Lors du réglage de la sonde, la fréquence d'accord en émission passe de 700,13 MHz, pour le cas de la figure 2A, à 700,49 MHz pour celui de la figure 2B.

Pour obtenir ces spectres, 700 acquisitions de 0,32 s comprenant chacune 2048 points complexes ont été enregistrées et les spectres de puissance calculés. Les deux spectres ayant été acquis et reproduits dans les mêmes conditions, on peut noter également la diminution du niveau de bruit sur les bords résultant du filtrage numérique présent dans le schéma d'acquisition et de transformée de Fourier du spectromètre utilisé.

Les deux avantages, par rapport à l'état de l'art antérieur, d'un réglage de la sonde RMN de telle sorte que sa fréquence de résonance en réception corresponde à la fréquence de Larmor des spins nucléaires des atomes à détecter sont les suivants.

Si l'échantillon est tel que des effets d'amortissement cohérent sont présents, cet accord assure que le champ radiofréquence d'amortissement cohérent soit en parfaite quadrature de phase vis-à-vis de l'aimantation nucléaire (phasage du signal) ce qui se traduit par une raie de résonance symétrique. L'accord de la fréquence de résonance caractérisant l'invention s'effectue alors en ajustant au moins un premier paramètre de la sonde de manière à ce que le signal, qui initialement apparait comme sous la forme d'un mélange de la partie absorptive et dispersive d'une même Lorentzienne, ce que l'on peut donc considérer comme déphasé comme représenté sur la figure 2A, adopte après ajustement la forme d'une Lorentzienne en absorption pure, c'est-à-dire phasé comme représenté comme sur la figure 2B.

Une fois effectué cet ajustement propre à l'invention, il devient plus aisé de supprimer un pic résiduel de solvant, par exemple de l'eau, par des techniques connues en soi [6, 7].

Egalement, les spectres de bruit de spins sont ainsi obtenus en pure absorption rendant leurs applications telle que l'imagerie de bruit de spins plus sensibles [8].

On peut remarquer que, si l'on observe les figures 2A et 2B non plus du point de vue de la forme du signal, mais du point de vue du niveau moyen du signal, on revient à la deuxième méthode de réalisation de l'invention. Il s'agit alors d'effectuer l'ajustement de manière à obtenir la valeur extrémale de cette valeur moyenne (matérialisée par une ligne horizontale pointillée). Puisque la figure représente un niveau de signal en puissance (donc positif), cette valeur extrémale correspond à la valeur maximale de l'amplitude de cette valeur moyenne (ordonnée de la ligne pointillée) lorsque l'on fait varier l'élément ajustable.

De manière plus générale et plus avantageuse, le fait que le circuit de détection soit accordé sur la fréquence de Larmor des spins, assure qu'aucune partie du faible signal RMN ne soit perdue par réflexion entre la sonde et le convertisseur analogique-numérique. Cela se traduit par un accroissement de signal, que l'on peut également associer à l'amélioration du facteur de qualité de la bobine à la fréquence de travail, en l'espèce la fréquence de Larmor.

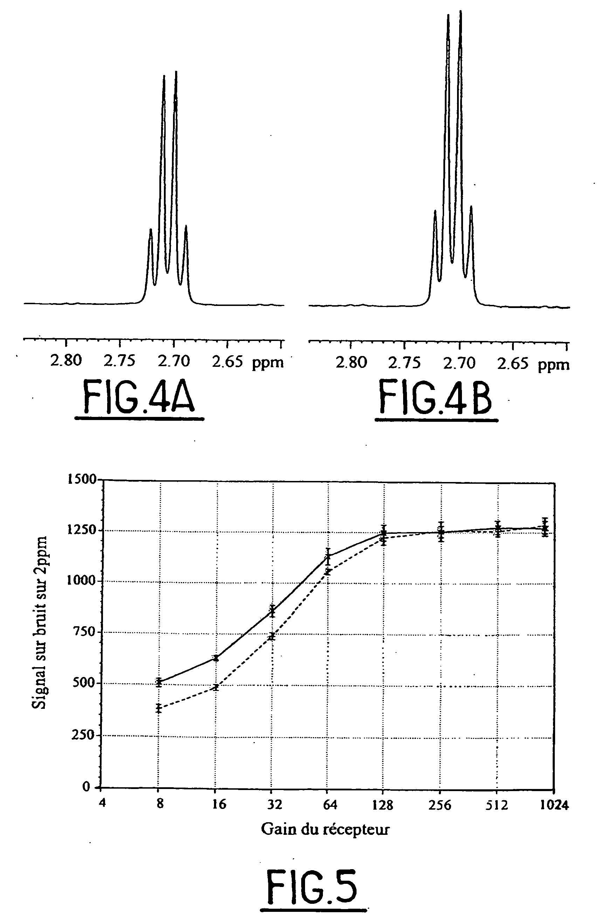

Ce résultat est illustré par la comparaison des figures 4A et 4B qui représentent une partie du spectre d'un échantillon d'éthyl-benzène à 0,02% dans 500 µl de chloroforme deutéré (CDCl₃), celle correspondant au quadruplet du CH₂ du groupement éthylique, est représentée. Les deux sous spectres correspondent à une acquisition simple après une impulsion de 90° faite sur un spectromètre Bruker Avance II fonctionnant à 700MHz et équipé d'une cryosonde TCI.

Le spectre 4A a été obtenu en ajustant les valeurs des capacités Cₘ et Cₜ des condensateurs ajustables de manière à accorder la sonde en émission à la fréquence de Larmor f₀= 700,13MHz. Le spectre 4B a été obtenu en ajustant les valeurs des capacités Cₘ et Cₜ de manière à accorder la sonde en réception ; dans ces conditions, la fréquence de résonance en émission était de 700,33MHz.

La comparaison des intensités des signaux (I_{B}-I_{A})/I_{A} indique une amélioration de 28% (31,5% pour une comparaison des intégrales) quand l'accord est fait en réception.

Cette amélioration du signal, valable dans tous les cas, peut également se traduire par une amélioration du rapport signal sur bruit. A titre d'exemple les courbes de la Figure 5 indiquent des valeurs moyennes de rapport signal sur bruit en fonction du niveau de gain du récepteur pour une sonde accordée en réception conformément à l'invention (trait plein) et pour une sonde identique accordée en émission selon l'art antérieur (trait pointillé). Chaque valeur de rapport signal sur bruit correspond à une moyenne effectuée sur les meilleures valeurs mesurées sur 5 à 10 spectres différents. Le bruit est calculé sur une plage de 2 ppm et le signal est calculé d'après le niveau de la résonance du groupement CH₂ de l'éthyl-benzène.

Des courbes similaires sont obtenues en utilisant d'autres sondes, d'autres spectromètres et des échantillons plus concentrés permettant d'observer une amélioration du rapport signal sur bruit jusqu'aux niveaux de gain de récepteur les plus bas ; le taux d'amélioration dépend du système considéré. On note clairement une amélioration de l'ordre de 30% pour toutes les valeurs de niveau de gain inférieur à 128. Les deux courbes, correspondant à un accord en émission et en réception, finissent par saturer à la même valeur ; la mise en oeuvre de l'invention est donc particulièrement avantageuse dans les cas où il faut opérer à un niveau de gain relativement bas. Cette valeur de saturation est liée à l'origine du bruit, qui pour ces valeurs de gain de récepteur est dominé par le bruit de la sonde et l'optimisation du préamplificateur en fonction du bruit de cette sonde. On peut, en particulier, noter que s'il y a toujours un gain en signal en ajustant l'accord de la sonde d'après la réception, le rapport signal sur bruit est toujours au moins égal et peut être supérieur. Cette approche est particulièrement intéressante dans le cas usuel où il y a coexistence d'un signal intense, par exemple associé au solvant ou au tampon, et d'un échantillon d'intérêt de faible concentration.

Le fait d'accorder la sonde RMN en réception est donc avantageux du point de vue de l'intensité du signal de résonance détecté et de son rapport signal sur bruit. Cependant, lorsque la sonde est accordée en réception, elle se trouve, par là même, désaccordée en émission. De plus, l'impédance d'entrée de la sonde vue par le générateur G n'est plus égale à 50 Ω.

Ce désaccord (en fréquence) et cette désadaptation (en impédance) se traduisent par un allongement de la durée de l'impulsion d'excitation (impulsion « à 90°») et par la réflexion d'une partie de sa puissance. A titre d'exemple dans le cas des figures 4A et 4B, la durée de l'impulsion à 90°, mesurée par la recherche de l'impulsion de 360°, est passée de 6,35 µs à 7,1 µs. Cet allongement peut s'avérer handicapant pour l'emploi de certaines séquences d'impulsions, en particulier celles incluant des trains d'impulsions à haute puissance de découplage ou de recouplage. En effet, il traduit le fait qu'une partie de la puissance émise par le générateur G est réfléchie vers celui-ci et peut dès lors perturber, voire empêcher, son bon fonctionnement.

On remarquera que l'accord d'impédance en réception entre la sonde S et le préamplificateur PA n'est généralement pas requis, et parfois est expressément évité.

Pour pallier la difficulté liée au désaccord et à la désadaptation de la sonde en émission, il est proposé d'adjoindre entre le premier élément de découplage ED1 et le générateur d'impulsions G (position A de la Figure 1) un élément électrique ajustable permettant d'assurer l'accord en fréquence et l'adaptation d'impédance en émission de la sonde avec le générateur d'impulsions connecté, sans pour autant perturber l'accord en fréquence en réception obtenu conformément à l'invention. Un tel élément ajustable peut être un circuit électrique ou électronique à base de capacités et/ou d'inductances variables et/ou de commutateurs rapides ; à titre d'exemple, un simple calcul d'électrocinétique indique qu'un circuit constitué de deux capacités variables, l'une en série (C₁) et l'autre en dérivation (C₂) de la sonde, placées au point A peut rendre possible le double accord en émission et en réception (voir figure 1b). En variante, cet élément ajustable peut être constitué par une ligne de transmission (un câble) de longueur variable connectant le point A et le circuit générateur G.

En conclusion, on procède de la manière qui suit.

Tout d'abord, les valeurs des capacités Cₜ et Cₘ des condensateurs ajustables sont ajustées de manière à accorder la sonde en réception tout en optimisant son facteur de qualité.

Cela induit par conséquent un désaccord de fréquence et une désadaptation d'impédance du circuit d'émission. Gardant constantes les valeurs des capacités Cₜ et Cₘ des condensateurs ajustables, on mesure, par exemple, par un coupleur coaxial bidirectionnel la tension émise par rapport à la tension réfléchie, ce qui est une indication de l'accord en fréquence et de l'adaptation d'impédance du circuit d'émission.

Puis, si nécessaire, on agit sur un élément électrique ajustable d'adaptation connecté au point A, ou sur la longueur du câble reliant le générateur d'impulsions G à la sonde S, pour adapter et accorder cette dernière en émission. Cet élément ajustable d'adaptation peut être un condensateur variable ou un circuit réactif, ou tout autre circuit induisant une modification de la réponse en fréquence et en impédance du circuit électronique. Lors d'un essai, la modulation de la longueur du câble a permis de réduire de 57% le taux de réflexion des impulsions d'excitation et de ramener leur durée de 7,1 µs à 6,65 µs (à comparer avec une durée de 6,35 µs lorsque la sonde est accordée uniquement en émission conformément à l'art antérieur).

Ces adaptations d'impédance effectuées sur la ligne d'émission n'influent pas sur l'amélioration de la sensibilité, comme le confirme la comparaison des rapports signal sur bruit. Celle-ci indique toujours que le réglage en réception est plus sensible que celui suivant l'émission, c'est-à-dire l'art antérieur. Il est cependant possible d'affiner encore le réglage en procédant de manière itérative.

Une autre variante de l'invention consiste à prévoir un élément électrique ajustable d'accord et d'adaptation entre le deuxième élément de découplage ED2 et le préamplificateur PA (position B de la Figure 1); comme dans le cas précédent, l'élément électrique ajustable peut être constitué par un circuit réactif (comportant, par exemple, les deux condensateurs C₁ et C₂ de la figure 1 b) et/ou par une ligne de transmission de longueur variable et/ou tout autre circuit modifiant la réponse en fréquence du circuit électronique de réception.

Dans ce cas, l'élément électrique ajustable disposé au point B est utilisé pour accorder la sonde en réception, tandis que les condensateurs ajustables de capacités Cₜ et Cₘ situées à proximité de la bobine assurent son accord et son adaptation en émission.

Les solutions peuvent être combinées, en prévoyant des circuits d'accord et adaptation aussi bien au niveau du point A que du point B.

### Références :

[1] D.I. Hoult, The NMR receiver: a description and analysis of design. Prog. NMR Spectrosc. 12 (1978) 41-77.
[2] A. Vlassenbroek, J. Jeener, and P. Broekaert, Radiation damping in high resolution liquid NMR: a simulation study. J. Chem. Phys. 103 (1995) 5886-5897.
[3] X.A. Mao, J.X. Guo, and C.H. Ye, Nuclear magnetic resonance line-shape theory in the présence of radiation damping. Phys. Rev. B 49 (1994) 15702-15711.
[4] M.A. McCoy, and R.R. Ernst, Nuclear spin noise at room temperature. Chem. Phys. Lett. 159 (1989) 587-593.
[5] T. Sleator, E.L. Hahn, C. Hilbert, and J. Clarke, Nuclear-spin noise and spontaneous emission. Phys. Rev. B 36 (1987) 1969-1980.
[6] M. Guéron, P. Plateau, and M. Decorps, Solvent signal suppression in NMR. Prog. NMR Spectrosc. 23 (1991) 135-209.
[7] V. Sklenar, M. Piotto, R. Leppik, and V. Saudek, Gradient-tailored water suppression for H-1-N-15 HSQC experiments optimized to retain full sensitivity. J. Magn. Reson. 102 (1993) 241-245.
[8] N. Müller, and A. Jerschow, Nuclear spin noise imaging. Proc. Natl Acad. Sci. USA 103 (2006) 6790-6792.

## Revendications

1. Procédé de réglage d'un circuit d'excitation et détection pour résonance magnétique nucléaire, comprenant une sonde (S), du type comportant une seule bobine (L) pour émettre des impulsions d'excitation des spins nucléaires d'un échantillon immergé dans un champ magnétique et pour détecter un signal de résonance desdits spins nucléaires, **caractérisé en ce qu'**il comprend l'accord de la fréquence de résonance en réception de ladite sonde à la fréquence de Larmor (f₀) des spins nucléaires des atomes à détecter au moyen d'au moins un élément électrique ajustable (Cₜ, Cₘ), et l'accord de la fréquence de résonance en émission de ladite sonde à la fréquence de Larmor (f₀) des spins nucléaires des atomes à détecter, ainsi que son adaptation d'impédance avec un circuit de génération (G) desdites impulsions d'excitation des spins nucléaires, au moyen d'au moins un élément électrique ajustable distinct (C₁, C₂).

2. Procédé selon la revendication 1, dans lequel ladite étape d'accord de la fréquence de résonance en réception de ladite sonde à la fréquence de Larmor comporte l'ajustement d'au moins un premier paramètre de réglage et l'observation de l'effet dudit ajustement sur le spectre du bruit électrique aux bornes d'un circuit résonant comprenant ladite bobine, en présence d'un échantillon à analyser par résonance magnétique nucléaire immergé dans un champ magnétique.

3. Procédé selon la revendication 2, dans lequel ledit spectre de bruit est mesuré pendant que l'on ajuste au moins ledit premier paramètre de réglage, ce paramètre étant ajusté jusqu'à ce que le maximum dudit spectre de bruit coïncide avec ladite fréquence de Larmor (f₀).

4. Procédé selon la revendication 3, dans lequel ledit spectre de bruit est mesuré à l'aide d'un analyseur de spectre électronique.

5. Procédé selon la revendication 2, dans lequel ladite étape d'accord de la fréquence de résonance en réception dudit circuit d'excitation et détection à la fréquence de Larmor comporte :
- la détermination, à l'aide d'un spectromètre à résonance magnétique nucléaire, d'un décalage entre la fréquence (fᵣ) en correspondance de laquelle ledit spectre de bruit présente son maximum d'intensité et ladite fréquence de Larmor (f₀) ; et
- l'accord en émission du circuit d'excitation et détection à la fréquence de Larmor modifiée dudit décalage.

6. Procédé selon la revendication 5, dans lequel les sous-étapes de détermination dudit décalage et d'accord en émission dudit circuit d'excitation et détection sont répétées de manière itérative.

7. Procédé selon la revendication 2, dans lequel ladite étape d'accord de la fréquence de résonance en réception de ladite sonde à la fréquence de Larmor comporte :
- la mesure d'un spectre de bruit de spins ; et
- l'ajustement d'au moins ledit premier paramètre de réglage jusqu'à ce que ledit spectre de bruit de spins présente un pic d'absorption pure.

8. Procédé selon l'une des revendications précédentes, dans lequel l'accord de la fréquence de résonance en réception dudit circuit d'excitation et détection à la fréquence de Larmor des spins nucléaires des atomes à détecter comporte l'ajustement simultané d'au moins un premier (Cₜ) et un deuxième (Cₘ) paramètre, afin d'optimiser le facteur de qualité de ladite sonde en même temps que l'on accorde sa fréquence de résonance.

9. Procédé selon la revendication 8, dans lequel ledit premier paramètre de réglage est la valeur de la capacité d'un premier condensateur (Cₜ) disposé en parallèle à ladite bobine (L).

10. Procédé selon la revendication 9, dans lequel ledit deuxième paramètre de réglage est la valeur de la capacité d'un deuxième condensateur (Cₘ) disposé en série par rapport au montage en parallèle de ladite bobine (L) et dudit premier condensateur (Cₜ).

11. Procédé selon l'une des revendications 2 à 10, comportant également une étape d'ajustement d'au moins un troisième paramètre de réglage, jusqu'à obtenir une adaptation d'impédance du circuit d'excitation et détection avec un circuit de génération (G) de ladite impulsion d'excitation des spins nucléaires, ledit troisième paramètre étant choisi de manière à ne pas affecter, de moins en première approximation, l'accord de la fréquence de résonance en réception dudit circuit d'excitation et détection.

12. Procédé selon la revendication 11, comportant également une étape d'ajustement d'au moins un quatrième paramètre de réglage, jusqu'à obtenir un accord en émission du circuit d'excitation et détection à la fréquence de Larmor, ledit quatrième paramètre étant choisi de manière à ne pas affecter, de moins en première approximation, l'accord de la fréquence de résonance en réception dudit circuit d'excitation et détection.

13. Procédé selon la revendication 11 ou 12, dans lequel l'adaptation d'impédance du circuit d'excitation et détection avec un circuit de génération de ladite impulsion d'excitation des spins nucléaires, ainsi que son accord en émission à la fréquence de Larmor, sont obtenus par réglage d'au moins un élément électrique ajustable (A, C₁, C₂) situé sur une ligne de transmission reliant un circuit résonant comprenant ladite bobine à un circuit de génération (G) desdites impulsions d'excitation des spins nucléaires, ledit élément électrique ajustable étant séparé dudit circuit résonant comprenant la bobine (L) par un élément de découplage (ED1) vu comme un circuit ouvert par le signal de résonance de spin détecté par ladite bobine.

14. Procédé selon la revendication 11 ou 12, dans lequel l'accord de fréquence en réception dudit circuit d'excitation et détection est obtenu par réglage d'au moins un élément électrique ajustable (B, C₁, C₂) situé à l'entrée d'un circuit de préamplification (PA) d'un signal de résonance de spin reçu par ladite bobine, ledit élément électrique ajustable étant séparé de ladite bobine par un élément de découplage (ED2) vu comme un court-circuit à la masse du circuit par les impulsions d'excitation des spins nucléaires.

15. Procédé selon la revendication 14, dans lequel l'adaptation d'impédance dudit circuit d'excitation et détection avec un circuit de génération (G) de ladite impulsion d'excitation des spins nucléaires, ainsi que son accord en émission à la fréquence de Larmor, sont obtenus par ajustement des valeurs de capacité d'un premier et d'un deuxième condensateurs disposés respectivement en parallèle à ladite bobine (Cₜ) et en série au montage en parallèle de ladite bobine (L) et dudit premier condensateur (Cₜ).

16. Procédé selon l'une des revendications 11 à 15, dans lequel lesdites étapes d'accord de fréquence en réception, et d'adaptation d'impédance et accord de fréquence en émission de ladite sonde, sont répétées de manière itérative.

17. Circuit d'excitation et détection pour résonance magnétique nucléaire, comprenant une sonde (S), du type comportant une seule bobine (L) pour émettre des impulsions d'excitation des spins nucléaires d'un échantillon immergé dans un champ magnétique et pour détecter un signal de résonance desdits spins nucléaires, ledit circuit étant **caractérisé en ce qu'**il est adapté à la mise en oeuvre d'un procédé de réglage selon l'une des revendication 11 à 16 **en ce qu'**il comporte :
- au moins un élément électrique ajustable pour permettre l'accord de la fréquence de résonance en réception de ladite sonde à la fréquence de Larmor (f₀) des spins nucléaires des atomes à détecter ; et
- au moins un élément électrique ajustable distinct pour permettre l'accord de la fréquence de résonance en émission de ladite sonde à la fréquence de Larmor (f₀) des spins nucléaires des atomes à détecter, ainsi que son adaptation d'impédance avec un circuit de génération (G) de ladite impulsion d'excitation des spins nucléaires.

18. Circuit d'excitation et détection pour résonance magnétique nucléaire selon la revendication 17, dans lequel au moins un dit élément électrique ajustable (A, C₁, C₂) est situé sur une ligne de transmission reliant ladite bobine à un circuit de génération (G) de ladite impulsion d'excitation des spins nucléaires, ledit élément électrique ajustable étant séparé de la bobine par un élément de découplage vu comme un circuit ouvert par le signal de résonance de spin détecté par ladite bobine.

19. Circuit d'excitation et détection pour résonance magnétique nucléaire selon la revendication 17, dans lequel ledit ou au moins un élément électrique ajustable pour permettre l'accord de la fréquence de résonance en réception de ladite sonde à la fréquence de Larmor (f₀) des spins nucléaires des atomes à détecter est situé à l'entrée d'un circuit de préamplification (PA) d'un signal de résonance de spin reçu par ladite bobine et est séparé de ladite bobine par un élément de découplage vu comme un court-circuit à la masse du circuit par l'impulsion d'excitation des spins nucléaires.

## Claims

1. A method of adjusting an excitation and detection circuit for nuclear magnetic resonance, comprising a probe (S) of the type comprising a single coil (L) for transmitting pulses to excite the nuclear spins of a sample immersed in a magnetic field and for detecting a resonance signal from said nuclear spins, **characterized by** the fact that it comprises tuning the resonant frequency in reception of said probe to the Larmor frequency (f₀) of the nuclear spins of the atoms that are to be detected using at least one adjustable electrical element (Cₜ, Cₘ), and tuning the resonant frequency in emission of said probe to the Larmor frequency (f₀) of the nuclear spins of the atoms that are to be detected, as well as its impedance match with a generation circuit (G)of said pulses to excite the nuclear spins using at least one separate adjustable electrical element (C₂).

2. A method according to claim 1, in which said step of tuning the resonant frequency in reception of said probe to the Larmor frequency includes adjusting at least a first adjustment parameter and observing the effect of said adjustment on the electrical noise spectrum at the terminals of a resonant circuit including said coil, in the presence of a sample immersed in a magnetic field for analysis by nuclear magnetic resonance.

3. A method according to claim 2, in which said noise spectrum is measured while adjusting at least said first adjustment parameter, said parameter being adjusted until the maximum of said noise spectrum coincides with said Larmor frequency (f₀).

4. A method according to claim 3, in which said noise spectrum is measured by using an electronic spectrum analyzer.

5. A method according to claim 2, in which said step of tuning the resonant frequency in reception of said excitation and detection frequency to the Larmor frequency comprises:
• using a nuclear magnetic resonance spectrometer to determine an offset between said Larmor frequency (f₀) and the frequency (fᵣ) at which said noise spectrum presents its intensity maximum; and
• tuning the excitation and detection circuit in transmission to the Larmor frequency modified by said offset.

6. A method according to claim 5, in which the sub-steps of determining said offset and tuning in transmission of said excitation and detection circuit are repeated iteratively.

7. A method according to claim 2, in which said step of tuning the resonant frequency in reception of said probe to the Larmor frequency comprises:
• measuring a spin noise spectrum; and
• adjusting at least said first adjustment parameter until said spin noise spectrum presents a pure absorption peak.

8. A method according to any preceding claim, in which the tuning of the resonant frequency in reception of said excitation and detection circuit to the Larmor frequency of the nuclear spins of the atoms for detection includes simultaneous adjustment of at least first and second parameters (Cₜ, Cₘ), in order to optimize the Q factor of said probe at the same time as tuning its resonant frequency.

9. A method according to claim 8, in which said first adjustment parameter is the value of the capacitance of a first capacitor (Cₜ) connected in parallel with said coil (L).

10. A method according to claim 9, in which said second adjustment parameter is the value of the capacitance of a second capacitor (Cₘ) connected in series with the parallel connection of said coil (L) and said first capacitor (Cₜ).

11. A method according to any of claims 2 to 10, also including a step of adjusting at least a third adjustment parameter in order to obtain an impedance match between the excitation and detection circuit and a circuit (G) for generating said nuclear spin excitation pulse, said third parameter being selected so as to avoid affecting, at least to a first approximation, the tuning of the resonant frequency in reception of said excitation and detection circuit.

12. A method according to claim 11, also including a step of adjusting at least a fourth adjustment parameter, to obtain tuning in transmission of the excitation and detection circuit on the Larmor frequency, said fourth parameter being selected so as to avoid affecting, at least to a first approximation, the tuning of the resonant frequency in reception of said excitation and detection circuit.

13. A method according to claim 11 or claim 12, in which the steps of adapting the impedance of the excitation and detection circuit to that of the circuit for generating said nuclear spin excitation pulse, and of tuning in transmission to the Larmor frequency, are performed by adjusting at least one adjustable electrical element (A, C₁, C₂) situated on a transmission line connecting a resonant circuit including said coil to a circuit (G) for generating said nuclear spin excitation pulses, said adjustable electrical element being separated from said resonant circuit including the coil (L) by a decoupling element (ED1) that is seen as an open circuit by the spin resonance signal detected by said coil.

14. A method according to claim 11 or claim 12, in which the frequency tuning in reception of said excitation and detection circuit is performed by adjusting at least one adjustable element (B, C₁, C₂) situated at the input of a preamplifier circuit (PA) for amplifying a spin resonance signal received by said coil, said adjustable electrical element being separated from said coil by a decoupling element (ED2) seen as a short circuit to circuit ground by the nuclear spin excitation pulses.

15. A method according to claim 14, in which the steps of matching the impedance of the excitation and detection circuit to that of a circuit (G) for generating said nuclear spin excitation pulse, and of tuning in transmission to the Larmor frequency, are performed by adjusting the capacitance values of first and second capacitors disposed respectively in parallel with said coil (Cₜ) and in series with the parallel connection of said coil (L) and said first capacitor (Cₜ).

16. A method according to any one of claims 11 to 15, in which said steps of tuning the frequency of said probe in reception and of matching its impedance and of tuning its frequency in transmission are repeated iteratively.

17. An excitation and detection circuit for nuclear magnetic resonance, the circuit including a probe (S) of the type comprising a single coil (L) transmitting pulses for exciting the nuclear spins of a sample immersed in a magnetic field and for detecting a resonant signal from said nuclear spins, said circuit being **characterized in that** it is adapted to implement an adjustment method according to any one of claims 11 to 16 and **in that** it includes:
• at least one adjustable electrical element for enabling the resonant frequency in reception of said probe to be tuned to the Larmor frequency (f₀) of the nuclear spins of the atoms to be detected; and
• at least one separate adjustable electrical element enabling the resonant frequency in transmission of said probe to be tuned to the Larmor frequency (f₀) of the nuclear spins of the atoms to be detected, and enabling the impedance thereof to be matched to that of a circuit (G) for generating said nuclear spin excitation pulse.

18. An excitation and detection circuit for nuclear magnetic resonance according to claim 17, in which at least one said adjustable electrical element (A, C₁, C₂) is situated on a transmission line connecting said coil to a circuit (G) for generating said nuclear spin excitation pulse, said reactive element being separated from the coil by a decoupling element seen as an open circuit by the spin resonance signal detected by said coil.

19. An excitation and detection circuit for nuclear magnetic resonance according to claim 17, in which said or at least one adjustable electrical element for tuning the resonant frequency in reception of said probe to the Larmor frequency (f₀) of the nuclear spins of the atoms that are to be detected is situated at the input of a preamplifier circuit (PA) for amplifying a spin resonance signal received by said coil and separated from said coil by a decoupling element seen as a short circuit to circuit ground by the nuclear spin excitation pulse.

## Patentansprüche

1. Verfahren zum Regeln einer Anregungs- und Detektionsschaltung für Kernspinresonanz, umfassend eine Sonde (S) vom Typ mit einer einzigen Spule (L) zum Emittieren von Anregungsimpulsen für Kernspins einer Probe, welche in einem Magnetfeld aufgenommen ist, und zum Detektieren eines Resonanzsignals der Kernspins, **dadurch gekennzeichnet, dass** es den Abgleich der Empfangsresonanzfrequenz der Sonde mit der Larmorfrequenz (f₀) von Kernspins von zu detektierenden Atomen mithilfe wenigstens eines anpassbaren elektrischen Elements (Cₜ, Cₘ) und den Abgleich der Emissionsresonanzfrequenz der Sonde mit der Larmorfrequenz (f₀) von Kernspins von zu erfassenden Atomen sowie ihre Impedanzanpassung mit einer Erzeugungsschaltung (G) für die Impulse zur Anregung der Kernspins mithilfe wenigstens eines unterschiedlichen anpassbaren elektrischen Elements (C₁, C₂) umfasst.

2. Verfahren nach Anspruch 1, wobei der Schritt des Abgleichs der Empfangsresonanzfrequenz der Sonde mit der Larmorfrequenz die Anpassung wenigstens eines ersten Regelparameters und die Beobachtung der Auswirkung der Anpassung auf das elektrische Rauschspektrum an Anschlüssen eines die Spule umfassenden Resonanzkreises, bei Vorhandensein einer in einem Magnetfeld aufgenommenen durch Kernspinresonanz zu analysierenden Probe umfasst.

3. Verfahren nach Anspruch 2, wobei das Rauschspektrum gemessen wird, während wenigstens der erste Regelparameter angepasst wird, wobei dieser Parameter angepasst wird, bis das Maximum des Rauschspektrums mit der Larmorfrequenz (f₀) zusammenfällt.

4. Verfahren nach Anspruch 3, wobei das Rauschspektrum mithilfe eines elektronischen Spektrumanalysators gemessen wird.

5. Verfahren nach Anspruch 2, wobei der Schritt des Abgleichs der Empfangsresonanzfrequenz der Anregungs- und Detektionsschaltung mit der Larmorfrequenz umfasst:
- die Bestimmung, mithilfe eines Kernspinresonanzspektrometers, eines Versatzes zwischen der Frequenz (fᵣ) in Entsprechung zu derjenigen, an welcher das Rauschspektrum seine Maximalintensität aufweist, und der Larmorfrequenz (f₀); und
- den Emissionsabgleich der Anregungs- und Detektionsschaltung mit der durch die Verschiebung modifizierten Larmorfrequenz.

6. Verfahren nach Anspruch 5, wobei die Unterschritte einer Bestimmung der Verschiebung und des Emissionsabgleichs der Anregungs- und Detektionsschaltung auf iterative Weise wiederholt werden.

7. Verfahren nach Anspruch 2, wobei der Schritt des Abgleichs der Empfangsresonanzfrequenz der Sonde mit der Larmorfrequenz umfasst:
- die Messung eines Spinrauschspektrums; und
- die Anpassung wenigstens des ersten Regelparameters bis das Spinrauschspektrum eine reine Absorptionsspitze aufweist.

8. Verfahren nach einem der vorhergehenden Ansprüche, wobei der Abgleich der Empfangsresonanzfrequenz der Anregungs- und Detektionsschaltung mit der Larmorfrequenz von Kernspins von zu erfassenden Atomen die gleichzeitige Anpassung wenigstens eines ersten (Cₜ) und eines zweiten (Cₘ) Parameters umfasst, um den Qualitätsfaktor der Sonde zu optimieren, während gleichzeitig ihre Resonanzfrequenz abgeglichen wird.

9. Verfahren nach Anspruch 8, wobei der erste Regelparameter der Wert der Kapazität eines ersten Kondensators (Cₜ) ist, welcher parallel zu der Spule (L) angeordnet ist.

10. Verfahren nach Anspruch 9, wobei der zweite Regelparameter der Wert der Kapazität eines zweiten Kondensators (Cₘ) ist, welcher in Reihe bezüglich der Parallelanordnung der Spule (L) und des ersten Kondensators (Cₜ) angeordnet ist.

11. Verfahren nach einem der Ansprüche 2-10, umfassend außerdem einen Schritt einer Anpassung wenigstens eines dritten Regelparameters, bis eine Impedanzanpassung der Anregungs- und Detektionsschaltung mit einer Erzeugungsschaltung (G) des Anregungsimpulses für Kernspins erhalten wird, wobei der dritte Parameter derart gewählt ist, dass zumindest in erster Näherung der Abgleich der Empfangsresonanzfrequenz der Anregungs- und Detektionsschaltung nicht beeinträchtigt wird.

12. Verfahren nach Anspruch 11, umfassend außerdem einen Schritt einer Anpassung wenigstens eines vierten Regelparameters, bis ein Emissionsabgleich der Anregungs- und Detektionsschaltung mit der Larmorfrequenz erhalten wird, wobei der vierte Parameter derart gewählt wird, dass zumindest in erster Näherung der Abgleich der Empfangsresonanzfrequenz der Anregungs- und Detektionsschaltung nicht beeinträchtigt wird.

13. Verfahren nach Anspruch 11 oder 12, wobei die Impedanzanpassung der Anregungs- und Detektionsschaltung mit einer Erzeugungsschaltung für den Anregungsimpuls für Kernspins sowie ihr Emissionsabgleich mit der Larmorfrequenz erhalten werden durch Regelung wenigstens eines anpassbaren elektrischen Elements (A, C₁, C₂), welches sich auf einer Übertragungsleitung befindet, die einen die Spule umfassenden Resonanzkreis mit einer Erzeugungsschaltung (G) für die Impulse zur Anregung von Kernspins verbindet, wobei das anpassbare elektrische Element von dem die Spule (L) umfassenden Resonanzkreis durch ein Entkopplungselement (ED1) getrennt ist, welches dem über die Spule detektierten Spinresonanzsignal wie ein offener Stromkreis erscheint.

14. Verfahren nach Anspruch 11 oder 12, wobei der Empfangsfrequenzabgleich der Anregungs- und Detektionsschaltung erhalten wird durch Regelung wenigstens eines anpassbaren elektrischen Elements (B, C₁, C₂), welches sich am Eingang einer Schaltung (PA) zur Vorverstärkung eines über die Spule aufgenommenen Spinresonanzsignals befindet, wobei das anpassbare elektrische Element von der Spule durch ein Entkopplungselement (ED2) getrennt ist, welches den Anregungsimpulsen für Kernspins wie ein Kurzschluss mit der Masse der Schaltung erscheint.

15. Verfahren nach Anspruch 14, wobei die Impedanzanpassung der Anregungs- und Detektionsschaltung mit einer Erzeugungsschaltung (G) für den Anregungsimpuls für Kernspins sowie ihr Emissionsabgleich mit der Larmorfrequenz erhalten werden durch Anpassung von Kapazitätswerten eines ersten und eines zweiten Kondensators, welche parallel zu der Spule (Cₜ) bzw. in Reihe zu der Parallelanordnung der Spule (L) und des ersten Kondensators (Cₜ) angeordnet sind.

16. Verfahren nach einem der Ansprüche 11-15, wobei die Schritte des Empfangsfrequenzabgleichs sowie der Impedanzanpassung und des Emissionsfrequenzabgleichs der Sonde auf iterative Weise wiederholt werden.

17. Anregungs- und Detektionsschaltung für Kernspinresonanz, umfassend eine Sonde (S) vom Typ mit einer einzigen Spule (L) zum Emittieren von Anregungsimpulsen für Kernspins einer Probe, welche in einem Magnetfeld aufgenommen ist, und zum Detektieren eines Resonanzsignals der Kernspins, wobei die Schaltung **dadurch gekennzeichnet ist, dass** sie zum Einsatz eines Regelverfahrens nach einem der Ansprüche 11-16 ausgestaltet ist und dass sie umfasst:
- wenigstens ein anpassbares elektrisches Element, um den Abgleich der Empfangsresonanzfrequenz der Sonde mit der Larmorfrequenz (f₀) der Kernspins der zu detektierenden Atome zu ermöglichen; und
- wenigstens ein unterschiedliches anpassbares elektrisches Element, um den Abgleich der Emissionsresonanzfrequenz der Sonde mit der Larmorfrequenz (f₀) der Kernspins der zu detektierenden Atome sowie ihre Impedanzanpassung mit einer Erzeugungsschaltung (G) für den Anregungsimpuls für Kernspins zu ermöglichen.

18. Anregungs- und Detektionsschaltung für Kernspinresonanz nach Anspruch 17, wobei wenigstens eins der genannten anpassbaren elektrischen Elemente (A, C₁, C₂) sich auf einer Übertragungsleitung befindet, welche die Spule mit einer Erzeugungsschaltung (G) für den Anregungsimpuls für Kernspins verbindet, wobei das anpassbare elektrische Element von der Spule durch ein Entkopplungselement getrennt ist, welches dem durch die Spule detektierten Spinresonanzsignal wie ein offener Stromkreis erscheint.

19. Anregungs- und Detektionsschaltung für Kernspinresonanz nach Anspruch 17, wobei das oder wenigstens ein anpassbares elektrisches Element, um den Abgleich der Empfangsresonanzfrequenz der Sonde mit der Larmorfrequenz (f₀) der Kernspins der zu detektierenden Atome zu ermöglichen, sich am Eingang einer Schaltung (PA) zur Vorverstärkung eines durch die Spule aufgenommenen Spinresonanzsignals befindet und von der Spule durch ein Entkopplungselement getrennt ist, welches dem Anregungsimpuls für Kernspins wie ein Kurzschluss mit der Masse der Schaltung erscheint.
